# EUROPEAN PATENT APPLICATION

(11) **EP 4 701 357 A1**
(43) Date of publication of application: **25.02.2026**
(21) Application number: 23938251.8
(22) Date of filing: 04.12.2023
(51) Int. Cl.: H05K 7/20, H05K 5/02

(54) **POWER CONVERTER HAVING AIR-LIQUID COMPOSITE HEAT DISSIPATION UNIT, AND ENERGY STORAGE SYSTEM**

(30) Priority: 19.05.2023 CN 202310571987
(71) Applicant: Huawei Digital Power Technologies Co., Ltd., Shenzhen, Guangdong 518043 (CN)
(72) Inventor: ZHU, Fangqi, Shenzhen, Guangdong 518043 (CN); MENG, Hao, Shenzhen, Guangdong 518043 (CN); LI, Jiyang, Shenzhen, Guangdong 518043 (CN)
(74) Representative: Epping - Hermann - Fischer
(86) International application number: PCT/CN2023/136071
(87) International publication number: WO 2024/239584

(57) **Abstract**

This application relates to the field of heat dissipation units, and in particular, to a power converter with an air-liquid hybrid heat dissipation unit, and an energy storage system. The power converter includes a housing, a power converter, and the air-liquid hybrid heat dissipation unit. The power conversion circuit includes a circuit board and a power transistor. The circuit board and an upper cover plate of the housing are arranged in a stacked manner, and there is a gap for air circulation between a top of the circuit board and the upper cover plate of the housing. The power transistor is disposed between a bottom of the circuit board and a lower cover plate of the housing. The air-liquid hybrid heat dissipation unit includes a fan and a cooling plate. The cooling plate is attached to a side surface of the power transistor. The fan is disposed between the bottom of the circuit board and the lower cover plate of the housing. There is a gap for air circulation between the fan and a side plate of the housing. The power converter with the air-liquid hybrid heat dissipation unit disclosed in this application uses the cooling plate to dissipate heat for the power transistor that has a high heat dissipation requirement, and uses the fan to dissipate heat for air in a device. This helps improve heat dissipation efficiency and reduce heat dissipation costs.

## Description

This application claims priority to Chinese Patent Application 202310571987.1, filed with the China National Intellectual Property Administration on May 19, 2023, and entitled "POWER CONVERTER WITH AIR-LIQUID HYBRID HEAT DISSIPATION UNIT, AND ENERGY STORAGE SYSTEM", which is incorporated herein by reference in its entirety.

### TECHNICAL FIELD

This application relates to the field of heat dissipation units, and more specifically, to a power converter with an air-liquid hybrid heat dissipation unit, and an energy storage system.

### BACKGROUND

With rapid development of a new energy industry, an output power of a power converter gradually increases. Therefore, a higher requirement is also raised for a heat dissipation capability of the power converter. The power converter usually internally includes a power conversion module and a heat dissipation unit. Components included in the power conversion module mainly include a power transistor, an inductor, a relay, a lightning arrester, a Hall element, and the like. The power transistor, for example, an insulated-gate bipolar transistor (insulated-gate bipolar transistor, IGBT), is a hybrid fully-controlled voltage-driven power semiconductor component composed of a bipolar transistor and an insulated-gate field-effect transistor. The power transistor has advantages of high input impedance and low on-state voltage drop, is a key component for energy conversion and transfer, consumes a large amount of heat, and is a heat dissipation bottleneck component of the power conversion module.

Currently, mainstream heat dissipation units in the industry mainly include an air-cooled unit and a liquid-cooled unit. In the air-cooled unit, a power transistor is closely attached to a heat sink, and a fan is used to blow a radiator to meet a heat dissipation requirement of the power transistor. However, when an output power of the power conversion module is high, a quantity of power transistors and heat consumption increase accordingly. Consequently, it is difficult for the air-cooled unit to meet a heat dissipation requirement of a high heat flux density of the power transistor. In the liquid-cooled unit, a power transistor is closely attached to a cooling plate, coolant flows in the cooling plate, and heat is exchanged to meet a heat dissipation requirement of the power transistor. However, the liquid-cooled unit has high costs, and cannot well lower temperature of an entire module, for example, an inductor or a relay that is in the module and that is not in contact with the cooling plate.

Therefore, a heat dissipation unit used in a power converter is urgently needed, to meet a heat dissipation requirement of a high-heating component, improve heat dissipation efficiency, and reduce heat dissipation costs.

### SUMMARY

This application provides a power converter with an air-liquid hybrid heat dissipation unit, and an energy storage system. The air-liquid hybrid heat dissipation unit in the power converter uses a cooling plate to dissipate heat for a power transistor that has a high heat dissipation requirement, and uses a fan to dissipate heat for air in a device. This helps improve heat dissipation efficiency and reduce heat dissipation costs.

According to a first aspect, this application provides a power converter with an air-liquid hybrid heat dissipation unit. The power converter includes a housing, a power conversion circuit, and the air-liquid hybrid heat dissipation unit. The housing is configured to accommodate the power conversion circuit and the air-liquid hybrid heat dissipation unit. The power conversion circuit includes a circuit board and at least one power transistor. The circuit board and an upper cover plate of the housing are arranged in a stacked manner, and there is a gap between a top of the circuit board and the upper cover plate of the housing. The at least one power transistor is disposed between a bottom of the circuit board and a lower cover plate of the housing, and the at least one power transistor is electrically connected to the circuit board. The air-liquid hybrid heat dissipation unit includes a fan and at least one cooling plate. The at least one cooling plate is attached to a side surface of the at least one power transistor. The fan is disposed between the bottom of the circuit board and the lower cover plate of the housing. The fan is electrically connected to the circuit board. There is a gap between the fan and a side plate of the housing. The air-liquid hybrid heat dissipation unit in the power converter provided in this application uses the cooling plate to dissipate heat for the power transistor that has a high heat dissipation requirement, and uses the fan to complete circulation and heat dissipation for air in the housing along a gap among components. This improves heat dissipation efficiency and reduces heat dissipation costs.

In an embodiment, the air-liquid hybrid heat dissipation unit further includes liquid collection chambers. The liquid collection chambers are arranged on two sides of the cooling plate and two sides of the power transistor, and there is a gap between the liquid collection chambers and a side plate of the housing. A first liquid-cooled interface set is provided on sides that are of the liquid collection chambers and that are close to the power transistor, and the first liquid-cooled interface set is configured to communicate with the at least one cooling plate. In this manner, the liquid collection chambers provide coolant for the cooling plate, and there is a gap between the liquid collection chambers and the housing of the power converter, so that air in the housing can be allowed to complete circulation and heat dissipation. This simplifies a structure of the air-liquid hybrid heat dissipation unit, and further reduces material costs.

In an embodiment, the liquid collection chambers have a coolant inlet and a coolant outlet, and the coolant inlet and the coolant outlet are arranged opposite to the fan. In this disposing manner, the coolant flows in and out of the liquid collection chamber from one end that is away from the fan, which facilitates maintenance of the air-liquid hybrid heat dissipation unit.

More specifically, the coolant inlet and the coolant outlet are located on different sides of the liquid collection chambers. In this manner, after entering the liquid collection chamber, the coolant flows to the cooling plate and another heat dissipation component at the same time, for example, to an air-liquid heat exchanger below, so that temperature in the housing of the power converter can be quickly lowered. Correspondingly, the coolant inlet and the coolant outlet are located on a same side of the liquid collection chambers, a partition plate is disposed inside the liquid collection chamber, and the partition plate is configured to partition the coolant inlet and the coolant outlet. In this manner, after entering the liquid collection chamber, the coolant may first flow to the cooling plate, and then flow to the air-liquid heat exchanger, so that heat dissipation can be preferentially performed for the power transistor that has a higher heat dissipation requirement.

In an embodiment, the air-liquid hybrid unit further includes the air-liquid heat exchanger. The air-liquid heat exchanger is located below the cooling plate, there is a gap between the air-liquid heat exchanger and a side plate of the housing, and in a projection perpendicular to a plane in a height direction of the housing, the air-liquid heat exchanger and the cooling plate are distributed in a staggered manner. A second liquid-cooled interface set is further provided on the sides that are of the liquid collection chambers and that are close to the power transistor, and the second liquid-cooled interface set is configured to communicate with the air-liquid heat exchanger. In this disposing manner, operation space is reserved below the cooling plate, which facilitates installation and maintenance of the power transistor and facilitates circulation and heat dissipation for air in the housing.

In an embodiment, a fin structure is provided on a side that is of the air-liquid heat exchanger and that is away from the fan, and the fin structure is configured to perform heat exchange between coolant in the air-liquid heat exchanger and air in the housing. In this disposing manner, air in the housing is blown by the fan, and circulates to the fin structure along a gap between each component and the housing. The fin structure transfers heat carried in the air to the coolant, thereby lowering the temperature in the housing of the power converter, and ensuring normal operation of each component.

In an embodiment, the power conversion circuit further includes an inductor. The inductor is disposed between the bottom of the circuit board and the lower cover plate of the housing, the inductor is electrically connected to the circuit board, and the inductor is arranged between the fan and the housing. In the projection perpendicular to the plane in the height direction of the housing, the inductor is located on a side that is of the fan and that is away from the cooling plate. In this disposing manner, air blown out by the fan first passes through the inductor, and then circulates to the air-liquid heat exchanger along a gap between each component and the housing, to complete heat dissipation for air in the housing, thereby improving heat dissipation efficiency.

In an embodiment, the power conversion circuit further includes a relay or a capacitor. In the projection perpendicular to the plane in the height direction of the housing, the relay or the capacitor is located on a side that is of the cooling plate and that is away from the fan. In this disposing manner, components such as the relay or the capacitor are disposed on the side that is close to the cooling plate but away from the fan. In this way, air blown out by the fan passes through the inductor and then sequentially passes through the relay or the capacitor, to complete heat dissipation for air in the housing, thereby improving heat dissipation efficiency. In addition, the relay or the capacitor is disposed on the side that is close to the cooling plate but away from the fan, so that operation space can also be reserved, to facilitate assembly and maintenance of the component.

In an embodiment, the power converter may be a power conversion system (power conversion system, PCS), a direct current-to-direct current (direct current-to-direct current, DC-DC) conversion device, a frequency converter, a converter, or a charging module.

According to a second aspect, this application further provides an energy storage system. The energy storage system includes an energy storage cabinet. The energy storage cabinet is configured to accommodate a battery pack and the power converter in the first aspect. In a height direction of the energy storage cabinet, the battery pack is located above or below the power converter. The energy storage cabinet includes a cabinet body and a cabinet door. The cabinet door is configured to close the cabinet body, and the cabinet body is configured to fasten the battery pack and the power converter. A mounting port is provided on a side that is of the cabinet door and that faces the power converter. The mounting port is configured to mount a liquid-cooled unit, and the liquid-cooled unit communicates with a coolant inlet and a coolant outlet. In a projection perpendicular to a plane in a height direction of the cabinet body, the liquid-cooled unit partially overlaps with the cabinet body. In this energy storage system, the cooling plate in the air-liquid hybrid heat dissipation unit is used to dissipate heat for the power transistor that has a high heat dissipation requirement, and the fan is used to complete circulation and heat dissipation for air in the housing along a gap among components. This improves heat dissipation efficiency and reduces heat dissipation costs. In addition, through a liquid-cooled pipe, the air-liquid hybrid heat dissipation unit is connected to a liquid-cooled unit fastened to the cabinet door. This improves installation convenience, and further increases space utilization of the cabinet body with not occupying or occupying less space of the cabinet body connected to the cabinet door.

In an embodiment, the energy storage system may be an energy storage cabinet or a charging pile.

### BRIEF DESCRIPTION OF DRAWINGS

FIG. 1 shows an example of an application scenario of this application;
FIG. 2 is a schematic diagram of a three-dimensional structure of a power converter with an air-liquid hybrid heat dissipation unit according to an embodiment of this application;
FIG. 3 is a front view and a side view of an air-liquid hybrid heat dissipation unit according to an embodiment of this application;
FIG. 4 is a front view and a side view of another air-liquid hybrid heat dissipation unit according to an embodiment of this application;
FIG. 5 is a schematic air direction diagram of a power converter with an air-liquid hybrid heat dissipation unit according to an embodiment of this application
FIG. 6 is another schematic air direction diagram of a power converter with an air-liquid hybrid heat dissipation unit according to an embodiment of this application;
FIG. 7 is still another schematic air direction diagram of a power converter with an air-liquid hybrid heat dissipation unit according to an embodiment of this application; and
FIG. 8 is a schematic diagram of a structure of an energy storage system according to an embodiment of this application.

### Reference numerals:

power converter-200; housing-210; circuit board-220; power conversion module-230; power transistor-231; inductor-232; first liquid collection chamber-2411; second liquid collection chamber-2412; partition plate-2413; cooling plate-242; fan-243; air-liquid heat exchanger-244; fin structure-2441; coolant inlet-245; coolant outlet-246; battery pack-300; energy storage system-800; energy storage cabinet-801; cabinet body-810; cabinet door-820; liquid-cooled unit-830; liquid-cooled terminal interface set-840; liquid-cooled pipe set-850.

### DESCRIPTION OF EMBODIMENTS

The following describes technical solutions of this application with reference to the accompanying drawings.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include forms such as "one or more", unless otherwise specified in the context clearly. It should be further understood that, in the following embodiments of this application, "at least one" and "one or more" mean one, two, or more. The term "and/or" is used to describe an association relationship between associated objects and represents that three relationships may exist. For example, A and/or B may represent the following cases: Only A exists, both A and B exist, and only B exists, where A and B each may be singular or plural. The character "/" generally represents an "or" relationship between the associated objects.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean reference to a same embodiment. Instead, the statements mean "one or more but not all of embodiments", unless otherwise specifically emphasized in another manner. The terms "include", "comprise", "have", and variations thereof all mean "including but not limited to", unless otherwise specified.

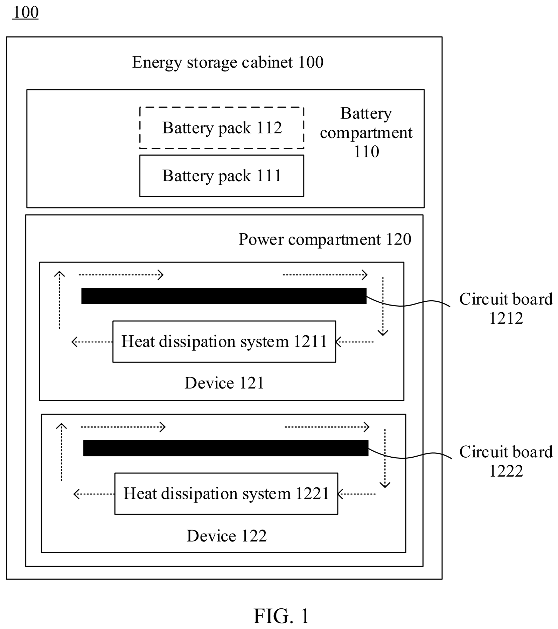

FIG. 1 shows an example of an application scenario of this application. As shown in FIG. 1, the scenario 100 may be an energy storage cabinet 100, which specifically includes a battery compartment 110 and a power compartment 120. Positions of the battery compartment 110 and the power compartment 120 may be interchangeable. The battery compartment 110 includes at least one battery pack 111. In an embodiment, to improve a capacity of the battery compartment 110, the battery compartment 110 may further include a plurality of battery packs, for example, include both the battery pack 111 and a battery pack 112. At least one device 121 is disposed in the power compartment 120, and the device 121 includes a circuit board 1212 and a heat dissipation system 1211. Although not shown in FIG. 1, a module that can implement a power conversion function, for example, a power conversion circuit, is disposed on the circuit board 1212. In an embodiment, a plurality of devices, for example, the device 121 and a device 122, may be further disposed in the power compartment 120. The device 121 and the device 122 are power supply devices that can implement a power conversion function, for example, a converter, a DC-DC conversion apparatus, or a power distribution module. That the battery compartment 110 includes the battery pack 111 is used as an example. After being processed by a DC-DC conversion apparatus, electrical energy stored in the battery pack 111 may directly provide a direct current to the outside, for example, a power supply apparatus of a vehicle-mounted battery. Alternatively, after electrical energy is processed by a DC-DC conversion apparatus and a converter in sequence, an alternating current is output to the outside, for example, electricity for living and production. In the conventional technology, in consideration of heat dissipation requirements and costs, the heat dissipation system 1211 may be an air-cooled heat dissipation system or a liquid-cooled heat dissipation system. In the air-cooled system, a fan is used to directly blow ambient air to an internal circuit board and component, to achieve heat dissipation. In the liquid-cooled system, a heat emitting component on a circuit board is attached to a cooling plate for heat dissipation, heat generated by the heat emitting component is brought out by coolant, and the circuit board can be isolated from an external environment, thereby implementing high protection and high reliability. However, both the air-cooled system and the liquid-cooled system have their limitations. For the air-cooled system, when an output power of a heat emitting component is large or there is a large quantity of heat emitting components, the air-cooled system cannot meet a heat dissipation requirement of a high heat flux density of the heat emitting component. Even if a heat equalizing capability can be improved through a heat pipe or the like to meet a part of the heat dissipation requirement, a required heat dissipation area is large, and a volume of a module is difficult to be small. In addition, in the air-cooled system, when the fan dissipates heat for the heat emitting component, a protection level of the module is difficult to be high, external air is in direct contact with the circuit board and the component for a long time, and corrosive substances, dust, water vapor, and the like in air may reduce long-term operating reliability of the module, increase a failure rate, and shorten a component life. Moreover, when the heat emitting component operates at full load or overload, the fan runs at a high speed and generates loud noise, which greatly affects a surrounding environment. For the liquid-cooled system, although the liquid-cooled system has a stronger heat dissipation capability, less noise, and a high protection level, complexity of the liquid-cooled system is high and costs are difficult to reduce.

As described in the background, different heat emitting components have heat dissipation requirements of different heat flux densities. For example, in this application, components in a power conversion module may be roughly classified into a high heat flux density component, a medium heat flux density component, and a low heat flux density component based on heat flux densities. The high heat flux density component may include a power transistor, an insulated-gate bipolar transistor (insulated-gate bipolar transistor, IGBT) module, or the like, the medium heat flux density component may include an inductor or the like, and the low heat flux density component may include a capacitor, a relay, a lightning arrester, a Hall element, or the like. In this way, different heat dissipation systems can be matched according to the heat dissipation requirements of different heat flux densities.

Based on the foregoing reasons, this application provides a power converter with an air-liquid hybrid heat dissipation unit, and an energy storage system, to meet heat dissipation requirements of different components, improve heat dissipation efficiency, and reduce heat dissipation costs.

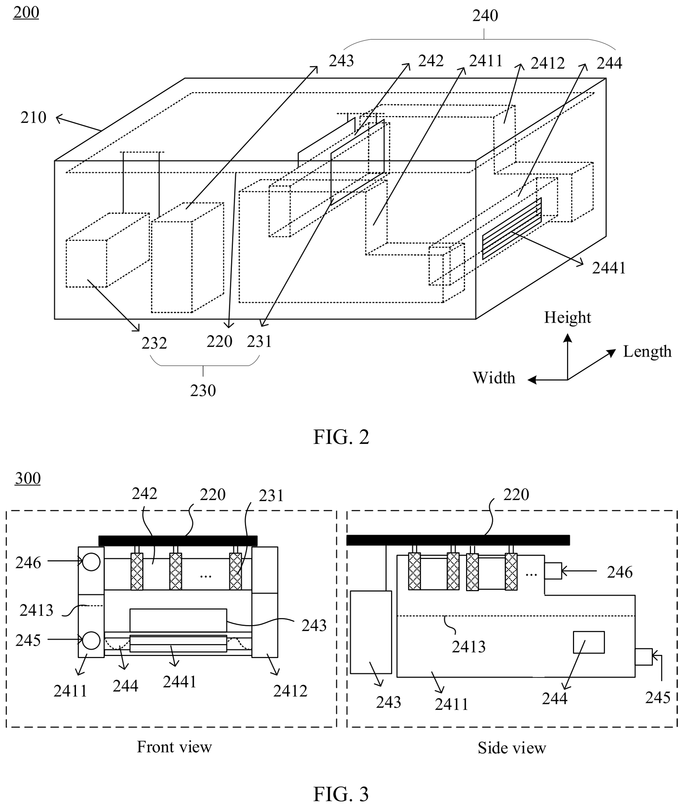

FIG. 2 is a schematic diagram of a three-dimensional structure of a power converter with an air-liquid hybrid heat dissipation unit according to an embodiment of this application. FIG. 3 is a front view and a side view of an air-liquid hybrid heat dissipation unit according to an embodiment of this application. The front view is a view of a plane facing a length direction of the power converter 200 shown in FIG. 2. The side view is a view of a plane facing a width direction of the power converter 200 shown in FIG. 2. Refer to FIG. 2 and FIG. 3. The power converter 200 includes a housing 210, a power conversion circuit 230, and an air-liquid hybrid heat dissipation unit 240. The housing 210 is configured to accommodate the power conversion circuit 230 and the air-liquid hybrid heat dissipation unit 240. The power conversion circuit 230 includes a circuit board 220 and at least one power transistor 231. The circuit board 220 and an upper cover plate of the housing 210 are arranged in a stacked manner, and there is a gap between a top of the circuit board 220 and the upper cover plate of the housing 210. The at least one power transistor 231 is disposed between a bottom of the circuit board 220 and a lower cover plate of the housing 210, and the at least one power transistor 231 is electrically connected to the circuit board 220. The air-liquid hybrid heat dissipation unit 240 includes a fan 243 and at least one cooling plate 242. The at least one cooling plate 242 is attached to a side surface of the at least one power transistor 231. The fan 243 is disposed between the bottom of the circuit board 220 and the lower cover plate of the housing 210.

The fan 243 is electrically connected to the circuit board 220. There is a gap between the fan 243 and a side plate of the housing 210. In this way, the air-liquid hybrid heat dissipation unit 240 in the power converter 200 uses the cooling plate 242 to dissipate heat for the power transistor 231 that has a high heat dissipation requirement, and uses the fan 243 to complete circulation and heat dissipation for air in the housing 210 along gaps among components. This improves heat dissipation efficiency and reduces heat dissipation costs.

In this embodiment of this application, a flow channel inside the cooling plate 242 may be a porous structure produced through an extrusion process. When coolant flows in the porous structure, a contact area between the coolant and the cooling plate 242 increases, to improve a heat dissipation capability of the cooling plate 242, and improve heat dissipation efficiency of a heat dissipation system. In an embodiment, according to different heat dissipation requirements, the cooling plate 242 may be produced by using a process method such as profile or aluminum extrusion or may be designed as a sandwich structure, to dissipate heat for a high heat flux density component such as the power transistor 231 (or an IGBT module). The power transistor 231 may be attached to the cooling plate 242 by using silicone grease, a ceramic sheet, and silicone grease for heat dissipation, and the IGBT module is attached to the cooling plate 242 by using silicone grease for heat dissipation. In an embodiment, a heat sink fin structure (not shown in the figure) is disposed in the flow channel of the cooling plate 242. The heat sink fin structure is configured to increase a turbulence degree of the coolant in the flow channel of the cooling plate 242 and the contact area between the coolant and the cooling plate 242, thereby further increasing a heat dissipation capability of the cooling plate 242, and improving heat dissipation efficiency of the heat dissipation system.

It should be noted that, when the cooling plate 242 and the power transistor 231 are installed, one cooling plate 242 may dissipate heat for two power transistors 231 at the same time. During actual installation, a correspondence between the cooling plate 242 and the power transistor 231 may be flexibly configured based on a quantity of power transistors 231 and actual requirements of the power transistors 231. For example, when there is a large quantity of power transistors 231, to save an installation area, a one-to-many correspondence between the cooling plate 242 and the power transistors 231 may be configured. In other words, one cooling plate 242 dissipates heat for a plurality of power transistors 231 at the same time. For another example, when the power transistor 231 has a high heat dissipation requirement, a many-to-one correspondence between the cooling plates 241 and the power transistor 231 may be configured. In other words, a plurality of cooling plates 242 dissipate heat for one power transistor 231 at the same time. For another example, a one-to-one correspondence between the cooling plate 242 and the power transistor 231 may alternatively be configured. This is not limited in this application.

Still refer to FIG. 2 and FIG. 3. The air-liquid hybrid heat dissipation unit further includes a liquid collection chamber 2411 and a liquid collection chamber 2412. The liquid collection chamber 2411 and the liquid collection chamber 2412 are arranged on two sides of the cooling plate 242 and two sides of the power transistor 231, and there is a gap between the liquid collection chamber 2411 and a side plate of the housing 210 and a gap between the liquid collection chamber 2412 and a side plate of the housing 210. A first liquid-cooled interface set (not shown in the figure) is provided on sides that are of the liquid collection chamber 2411 and the liquid collection chamber 2412 and that are close to the power transistor 231, and the first liquid-cooled interface set is configured to communicate with the at least one cooling plate 242. In this manner, the liquid collection chamber 2411 and the liquid collection chamber 2412 provide coolant for the cooling plate 242, and there is a gap between the liquid collection chamber 2411 and the housing 210 of the power converter and a gap between the liquid collection chamber 2412 and the housing 210 of the power converter, so that air in the housing 210 can be allowed to complete circulation and heat dissipation. This simplifies a structure of the air-liquid hybrid heat dissipation unit 240, and further reduces material costs.

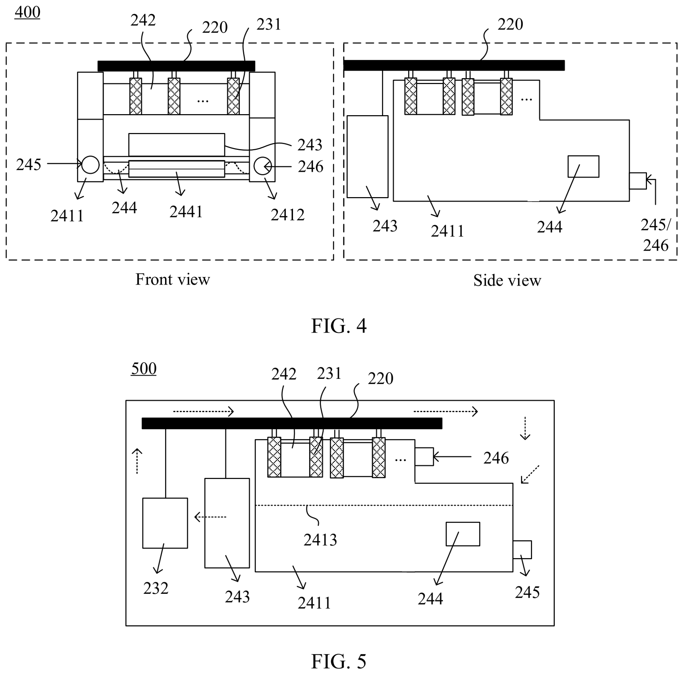

FIG. 4 is a front view and a side view of another air-liquid hybrid heat dissipation unit according to an embodiment of this application. The front view is a view of a plane facing a length direction of the power converter 200 shown in FIG. 2. The side view is a view of a plane facing a width direction of the power converter 200 shown in FIG. 2. Refer to FIG. 3 and FIG. 4. The liquid collection chambers have a coolant inlet and a coolant outlet, and the coolant inlet and the coolant outlet are arranged opposite to the fan. In this disposing manner, the coolant flows in and out of the liquid collection chamber 2411 and the liquid collection chamber 2412 from one end that is away from the fan 243, which facilitates maintenance of the air-liquid hybrid heat dissipation unit 240.

Refer to FIG. 3. In an embodiment, the coolant inlet 245 and the coolant outlet 246 are disposed on a same side of the liquid collection chamber 2411 and the liquid collection chamber 2412, for example, disposed on the liquid collection chamber 2411. A partition plate 2413 is further disposed inside the liquid collection chamber 2411. The partition plate 2413 is configured to partition the coolant inlet 245 and the coolant outlet 246. The coolant inlet 245 is located below the coolant outlet 246. In this manner, after entering the liquid collection chamber 2411, the coolant first flows to an air-liquid heat exchanger 244, then flows to the liquid collection chamber 2412, and subsequently flows to the cooling plate 242, so that temperature of air in the housing 210 can be preferentially lowered. Although not shown in the figure, in another embodiment, when both the coolant inlet 245 and the coolant outlet 246 are disposed on the liquid collection chamber 2411 and are partitioned by the partition plate 2413, the coolant inlet 245 may be alternatively located above the coolant outlet. In this manner, after entering the liquid collection chamber 2411, the coolant flows to the cooling plate 242, then flows to the liquid collection chamber 2412, and subsequently flows to the air-liquid heat exchanger 244, so that heat dissipation can be preferentially performed for the power transistor 231 that has a higher heat dissipation requirement. Refer to FIG. 4 again. In an embodiment, the coolant inlet 245 and the coolant outlet 246 are disposed on different sides of the liquid collection chambers. For example, the coolant inlet 245 is disposed on a side of the liquid collection chamber 2411, and the coolant outlet 246 is disposed on a side of the liquid collection chamber 2413. In this way, after entering a flow channel of the liquid collection chamber 2411 from the coolant inlet, the coolant flows to a flow channel of the air-liquid heat exchanger 244 and the flow channel of the cooling plate 242 at the same time. In other words, the flow channel of the air-liquid heat exchanger and the flow channel of the cooling plate are in a parallel relationship. In such a manner, after the coolant flows into the liquid collection chamber 2411, most of the coolant may flow to the flow channel in the cooling plate 242 to dissipate heat for the power transistor 231, and a small part of the coolant enters the air-liquid heat exchanger 244 to dissipate heat for air in the housing 210.

Still refer to FIG. 2, FIG. 3, and FIG. 4. In an embodiment, the air-liquid hybrid unit 240 further includes the air-liquid heat exchanger 244. The air-liquid heat exchanger 244 is located below the cooling plate 242, there is a gap between the air-liquid heat exchanger 244 and a side plate of the housing 210, and in a projection perpendicular to a plane in a height direction of the housing 210, the air-liquid heat exchanger 244 and the cooling plate 242 are distributed in a staggered manner. A second liquid-cooled interface set (not shown in the figure) is further provided on the sides that is of the liquid collection chamber 2411 and the liquid collection chamber 2412 and that are close to the power transistor 231, and the second liquid-cooled interface set is configured to communicate with the air-liquid heat exchanger 244. In this disposing manner, operation space is reserved below the cooling plate 242, which facilitates installation and maintenance of the power transistor 231 and facilitates circulation and heat dissipation for air in the housing 210. A fin structure 2441 is provided on a side that is of the air-liquid heat exchanger 244 and that is away from the fan 243, and the fin structure 2441 is configured to perform heat exchange between the coolant in the air-liquid heat exchanger 244 and air in the housing 210. In this disposing manner, air in the housing 210 is blown by the fan 243, and circulates to the fin structure 2441 along a gap between each component and the housing 210, thereby lowering the temperature in the housing 210 of the power converter, and ensuring normal operation of each component.

Still refer to FIG. 2. In an embodiment, the power conversion circuit 230 further includes an inductor 232. The inductor 232 is disposed between the bottom of the circuit board 220 and the lower cover plate of the housing 210, the inductor 232 is electrically connected to the circuit board 220, and there is a gap between the inductor 232 and a side plate of the housing 210. The inductor 232 is arranged between the fan 243 and the housing 210. In the projection perpendicular to the plane in the height direction of the housing 210, the inductor 232 is located on a side that is of the fan 243 and that is away from the cooling plate 242. In this disposing manner, air blown out by the fan 243 first passes through the inductor 232, and then circulates to the air-liquid heat exchanger 244 along the gap between each component and the housing 210, to complete heat dissipation for air in the housing 210, thereby improving heat dissipation efficiency.

In an embodiment, the power conversion circuit 230 further includes a relay or a capacitor. Although not shown in the figure, in the projection perpendicular to the plane in the height direction of the housing 210, the relay or the capacitor is located on a side that is of the cooling plate 242 and that is away from the fan 243. In this disposing manner, components such as the relay or the capacitor are disposed on the side that is close to the cooling plate 242 but away from the fan 243. In this way, air blown out by the fan 243 passes through the inductor 232 and then sequentially passes through the relay or the capacitor, to complete heat dissipation for air in the housing 210, thereby improving heat dissipation efficiency. In addition, the relay or the capacitor is disposed on the side that is close to the cooling plate 242 but away from the fan 243, so that operation space can also be reserved, to facilitate assembly and maintenance of the component.

FIG. 5 is a schematic air direction diagram of a power converter with an air-liquid hybrid heat dissipation unit according to an embodiment of this application. FIG. 5 is a side view of the power converter 200 shown in FIG. 2. The side view is a view of a plane facing a width direction of the power converter 200 shown in FIG. 2. Refer to FIG. 5. There is a gap between the inductor 232 and a side wall of the housing 210, there is the gap between the circuit board 220 and the upper cover plate of the housing 210, and there is the gap between the air-liquid heat exchanger 244 and a side wall of the housing 210. In this way, in a direction shown by dashed lines in FIG. 5, air blown out by the fan 243 may first pass through the inductor 232, return from the top of the circuit board 220, then sequentially pass through possible components such as a capacitor, a relay, a Hall element, a lightning arrester, and an auxiliary source, and finally enter the air-liquid heat exchanger 244 to lower the temperature, to complete circulation and heat dissipation. In this way, a volume of the power converter 200 is reduced.

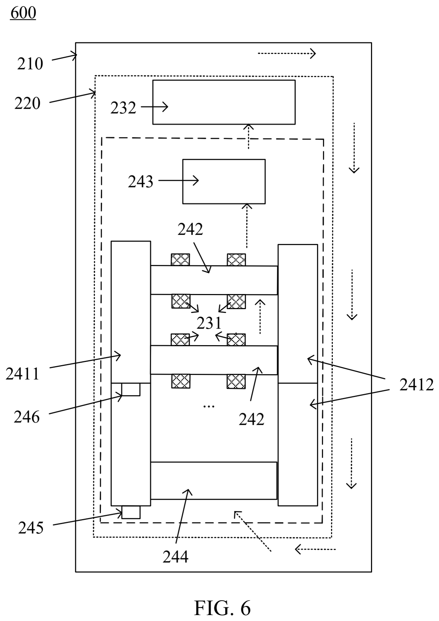

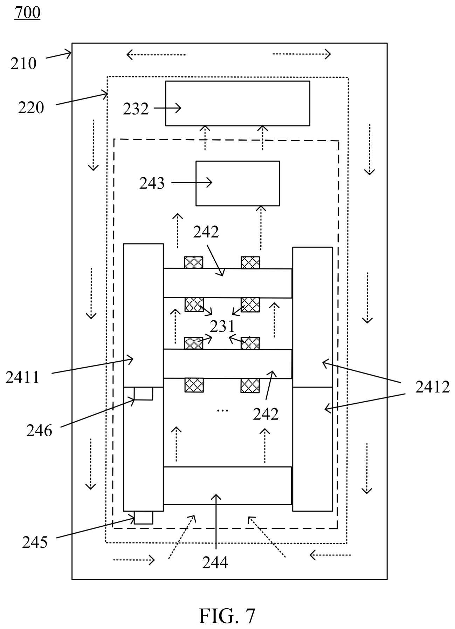

FIG. 6 is another schematic air direction diagram of a power converter with an air-liquid hybrid heat dissipation unit according to an embodiment of this application. FIG. 7 is still another schematic air direction diagram of a power converter with an air-liquid hybrid heat dissipation unit according to an embodiment of this application. FIG. 6 and FIG. 7 are both side views of the power converter 200 shown in FIG. 2. The top view is a view of a plane perpendicular to a height direction of the power converter 200 shown in FIG. 2. Refer to FIG. 6. There is a gap between the inductor 232 and a forward side wall of the housing 210, there is a gap between the circuit board 220 and a rightward side wall of the housing 210, and there is a gap between the air-liquid heat exchanger 244 and a backward side wall of the housing 210. In this way, in a direction shown by dashed lines in FIG. 6, air blown out by the fan 243 may first pass through the inductor 232, return from a right side of the circuit board 220, then sequentially pass through possible components such as a capacitor, a relay, a Hall element, a lightning arrester, and an auxiliary source, and finally enter the air-liquid heat exchanger 244 to lower the temperature, to complete circulation and heat dissipation. Refer to FIG. 7 again. There is a gap between the inductor 232 and a forward side wall of the housing 210, there is a gap between the circuit board 220 and a leftward side wall as well as a rightward side wall of the housing 210, and there is a gap between the air-liquid heat exchanger 244 and a backward side wall of the housing 210. In this way, in a direction shown by dashed lines in FIG. 7, air blown out by the fan 243 may first pass through the inductor 232, return from a left side and a right side of the circuit board 220, then sequentially pass through possible components such as a capacitor, a relay, a Hall element, a lightning arrester, and an auxiliary source, and finally enter the air-liquid heat exchanger 244 to lower the temperature, to complete circulation and heat dissipation.

It should be noted that, in an embodiment, the power converter 200 may use a combination of design solutions of top-side air return shown in FIG. 5 and single-side air return shown in FIG. 6. In this way, air circulation can be accelerated, and heat dissipation efficiency can be improved. In another embodiment, the power converter 200 may use a combination of design solutions of top-side air return shown in FIG. 5 and double-side air return shown in FIG. 7. In this case, although a volume of the power converter 200 is increased to some extent, an air circulation speed is faster and heat dissipation efficiency is better than the designs of the top-side air return and the single-side air return.

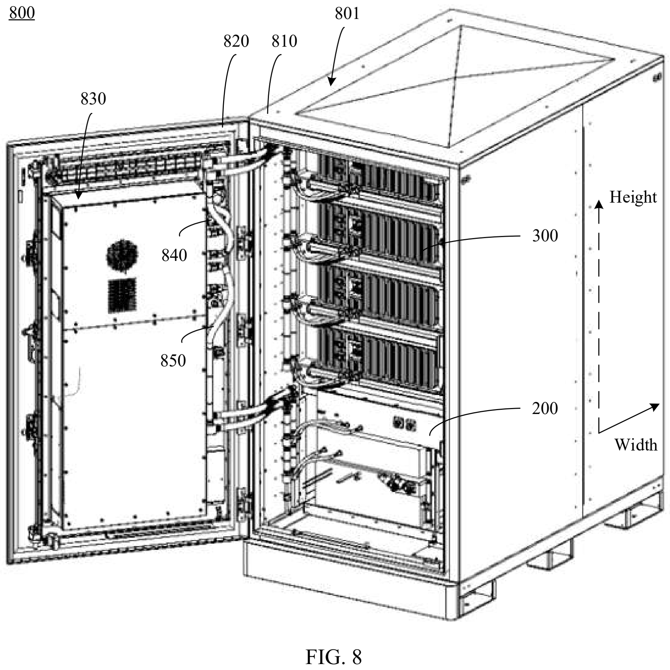

FIG. 8 is a schematic diagram of a structure of an energy storage system according to an embodiment of this application. Refer to FIG. 8. The energy storage system 800 includes an energy storage cabinet 801. The energy storage cabinet 801 is configured to accommodate a battery pack 300 and a power converter 200. In a height direction of the energy storage cabinet 801, the battery pack 300 is located above the power converter 200. The energy storage cabinet 801 includes a cabinet body 810 and a cabinet door 820. The cabinet door 820 is configured to close the cabinet body 810, and the cabinet body 810 is configured to fasten the battery pack 300 and the power converter 200. A mounting port (not shown in the figure) is disposed on a side that is of the cabinet door 820 and that faces the power converter 200. The mounting port is configured to mount a liquid-cooled unit 830, and the liquid-cooled unit 830 communicates with a coolant inlet 245 and a coolant outlet 246. In a projection perpendicular to a plane in a height direction of the cabinet body 810, the liquid-cooled unit 830 partially overlaps with the cabinet body 810. In this energy storage system, the cooling plate 242 in the air-liquid hybrid heat dissipation unit 240 is used to dissipate heat for the power transistor 231 that has a high heat dissipation requirement, and the fan 243 is used to complete circulation and heat dissipation for air in the housing 210 along a gap among components. This improves heat dissipation efficiency and reduces heat dissipation costs. In addition, by using a liquid-cooled pipe set 850, the air-liquid hybrid heat dissipation unit 240 is connected to the liquid-cooled unit 830 fastened to the cabinet door 820. This improves installation convenience, and further increases space utilization of the cabinet body 810 with not occupying or occupying less space of the cabinet body 810 connected to the cabinet door 820.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A power converter with an air-liquid hybrid heat dissipation unit, wherein the power converter comprises a housing, a power conversion circuit, and the air-liquid hybrid heat dissipation unit, and the housing is configured to accommodate the power conversion circuit and the air-liquid hybrid heat dissipation unit;
the power conversion circuit comprises a circuit board and at least one power transistor, wherein the circuit board and an upper cover plate of the housing are arranged in a stacked manner, and there is a gap between a top of the circuit board and the upper cover plate of the housing; and the at least one power transistor is disposed between a bottom of the circuit board and a lower cover plate of the housing, and the at least one power transistor is electrically connected to the circuit board; and
the air-liquid hybrid heat dissipation unit comprises a fan and at least one cooling plate, wherein the at least one cooling plate is attached to the at least one power transistor, the fan is disposed between the bottom of the circuit board and the lower cover plate of the housing, and there is a gap between the fan and a side plate of the housing.

2. The power converter according to claim 1, wherein the air-liquid hybrid heat dissipation unit further comprises liquid collection chambers, and the liquid collection chambers are arranged on two sides of the cooling plate and two sides of the power transistor.

3. The power converter according to claim 2, wherein a first liquid-cooled interface set is provided on sides that are of the liquid collection chambers and that are close to the power transistor, and the first liquid-cooled interface set is configured to communicate with the at least one cooling plate.

4. The power converter according to claim 2 or 3, wherein the liquid collection chambers have a coolant inlet and a coolant outlet, and the coolant inlet and the coolant outlet are arranged opposite to the fan.

5. The power converter according to claim 4, wherein the coolant inlet and the coolant outlet are located on a same side of the liquid collection chambers, a partition plate is disposed inside the liquid collection chamber, and the partition plate is configured to partition the coolant inlet and the coolant outlet.

6. The power converter according to any one of claims 1 to 5, wherein the air-liquid hybrid unit further comprises an air-liquid heat exchanger, the air-liquid heat exchanger is located below the cooling plate, there is a gap between the air-liquid heat exchanger and a side plate of the housing, and in a projection perpendicular to a plane in a height direction of the housing, the air-liquid heat exchanger and the cooling plate are distributed in a staggered manner.

7. The power converter according to claim 6, wherein a second liquid-cooled interface set is further provided on the sides that are of the liquid collection chambers and that are close to the power transistor, and the second liquid-cooled interface set is configured to communicate with the air-liquid heat exchanger.

8. The power converter according to claim 6 or 7, wherein a fin structure is provided on a side that is of the air-liquid heat exchanger and that is away from the fan, and the fin structure is configured to perform heat exchange between coolant in the air-liquid heat exchanger and air in the housing.

9. The power converter according to any one of claims 1 to 8, wherein the power conversion circuit further comprises an inductor, the inductor is disposed between the bottom of the circuit board and the lower cover plate of the housing, the inductor is electrically connected to the circuit board, and there is a gap between the inductor and a side plate of the housing.

10. The power converter according to claim 9, wherein in the projection perpendicular to the plane in the height direction of the housing, the inductor is arranged between the fan and the housing.

11. The power converter according to any one of claims 1 to 10, wherein the power conversion circuit further comprises a relay or a capacitor; and in the projection perpendicular to the plane in the height direction of the housing, the relay or the capacitor is located on a side that is of the cooling plate and that is away from the fan.

12. An energy storage system, wherein the energy storage system comprises an energy storage cabinet and at least one power converter according to any one of claims 1 to 11, the energy storage cabinet comprises a cabinet body and a cabinet door, the cabinet door is configured to close the cabinet body, and the cabinet body is configured to fasten the power converter.

13. The energy storage system according to claim 12, wherein the energy storage system comprises a battery pack, and in a height direction of the energy storage cabinet, the battery pack is located above or below the power converter.

14. The energy storage system according to claim 13, wherein a mounting port is provided on a side that is of the cabinet door and that faces the power converter, the mounting port is configured to mount a liquid-cooled unit, and the liquid-cooled unit communicates with the coolant inlet and the coolant outlet.

15. The energy storage system according to claim 14, wherein when the cabinet door closes the cabinet body, in a projection perpendicular to a plane in a height direction of the cabinet body, the liquid-cooled unit partially overlaps with the cabinet body.
